(19) Europäisches Patentamt
European Patent Office
Office européen des brevets

(11) EP 0 795 758 A1

(12) EUROPÄISCHE PATENTANMELDUNG

(43) Veröffentlichungstag:
17.09.1997 Patentblatt 1997/38

(51) Int. Cl.⁶: G01R 33/483

(21) Anmeldenummer: 97200649.8

(22) Anmeldetag: 05.03.1997

(84) Benannte Vertragsstaaten:
DE FR GB NL

(30) Priorität: 13.03.1996 DE 19609839

(71) Anmelder:
• Philips Patentverwaltung GmbH
22335 Hamburg (DE)
Benannte Vertragsstaaten:
DE
• Philips Electronics N.V.
5621 BA Eindhoven (NL)
Benannte Vertragsstaaten:
FR GB NL

(72) Erfinder:
• Schäffter, Tobias
Röntgenstrasse 24, 22335 Hamburg (DE)
• Börnert, Peter, Dr.
Röntgenstrasse 24, 22335 Hamburg (DE)

(74) Vertreter: Hartmann, Heinrich, Dipl.-Ing. et al
Philips Patentverwaltung GmbH,
Röntgenstrasse 24
22335 Hamburg (DE)

(54) MR-Spektroskopieverfahren

(57) Die Erfindung betrifft ein MR-Spektroskopieverfahren, bei dem durch mehrmals wiederholte Sequenzen die Kernmagnetisierung von mehreren, im Schnittbereich von je zwei Schichten befindlichen Volumenelementen gleichzeitig angeregt wird, wobei die dabei erfolgende Phasenkodierung der Volumenelemente von Sequenz zu Sequenz variiert wird und wobei die spektrale Verteilung der Kernmagnetisierung in den Volumenelementen aus Linearkombinationen der in den einzelnen Sequenzen erzeugten MR-Signale abgeleitet wird. Ein besonders einfaches robustes Verfahren mit einem guten Signal-Rausch-Verhältnis ergibt sich erfindungsgemäß dadurch, daß in jeder Sequenz

- ein erster schichtselektiver Hochfrequenzimpuls erzeugt wird zur Anregung der Transversalmagnetisierung in einer oder mehreren ersten Schichten, und
- danach ein zweiter schichtselektiver Hochfrequenzimpuls erzeugt wird zur Refokussierung der Kernmagnetisierung in einer oder mehreren zweiten Schichten, die die ersten Schichten unter einem von Null verschiedenen Winkel schneiden,

und daß in den verschiedendenen Sequenzen die durch die Spin-Echos in den im Schnittbereich von je einer ersten und einer zweiten Schicht befindlichen Volumenelementen hervorgerufenen MR-Signale erfaßt und zur Ermittlung der spektralen Verteilung der Kernmagnetisierung herangezogen werden.

Fig.2

**Beschreibung**

Die Erfindung betrifft ein MR-Spektroskopieverfahren, bei dem durch mehrmals wiederholte Sequenzen die Kernmagnetisierung von mehreren, im Schnittbereich von je zwei Schichten befindlichen Volumenelementen gleichzeitig angeregt wird, wobei die dabei erfolgende Phasenkodierung der Volumenelemente von Sequenz zu Sequenz variiert wird und wobei die spektrale Verteilung der Kernmagnetisierung in den Volumenelementen aus Linearkombinationen der in den einzelnen Sequenzen erzeugten MR-Signale abgeleitet wird, sowie eine Anordnung zur Durchführung dieses Verfahrens.

Verfahren dieser Art sind bekannt, und zwar aus

a) der EP-OS 0 339 979
b) Goelman in J. Magn. Reson. **B 104**, PP 212-218 (1994) und aus
c) Goelman et al in J. Magn. Reson. **89**, PP 437-454 (1990).

Im Vergleich zu MR-Verfahren, bei denen die spektrale Verteilung der Kernmagnetisierung in den einzelnen Volumenelementen nacheinander gemessen wird, haben diese Verfahren den Vorteil eines höheren Signal-Rausch-Verhältnisses. Bei den beiden in a) und b) beschriebenen Verfahren wird die Longitudinalmagnetisierung zunächst durch einen oder zwei schichtselektive 180°-Impulse schichtweise invertiert. Diese Kodierung wird mittels eines Ausleseimpulses, der die Longitudinalmagnetisierung im Gesamtuntersuchungsbereich - also nicht nur in den Volumenelementen - in Transversalmagnetisierung überführt, ausgelesen. Wenn das Volumen, in dem der 180°-Impuls wirksam war, wesentlich kleiner ist als das Gesamtvolumen der Volumenelemente, können erhebliche Meßfehler auftreten. Innerhalb einer Sequenz bzw. einer Repetitionszeit kann nur ein MR-Signal erfaßt werden - es sei denn, man liest die Longitudinalmagnetisierung nicht vollständig aus (wie bei b), um danach aus der verbliebenen Longitudinalmagnetisierung ein weiteres MR-Signal zu gewinnen. Dadurch verschlechtert sich jedoch das Signal-Rausch-Verhältnis.

Bei dem aus c) bekannten Verfahren wird durch einen ersten 90°-Hochfrequenzimpuls die Transversalmagnetisierung in einer oder mehreren Schichten angeregt. Die Sequenz enthält neben refokussierenden 180°-Impulsen noch zwei weitere 90°-Hochfrequenzimpulse, die die Kernmagnetisierung in weiteren Schichten beeinflussen, die zu den zuvor angeregten Schichten senkrecht verlaufen. Die Volumenelemente sind dabei durch den Schnittbereich dreier zueinander senkrechter Schichten definiert, und es werden die darin erzeugten stimulierten Echosignale ausgelesen. Ein Nachteil dieses Verfahrens besteht darin, daß dabei grundsätzlich 50 % der Signalenergie verlorengeht. Ein weiterer Nachteil besteht darin, daß man innerhalb einer Sequenz dieses Verfahren nicht auf andere Volumenelemente anwenden kann - es sei denn, man liest mit dem dritten Hochfrequenzimpuls die zwei vorangegangenen Hochfrequenzimpulse im Schnittbereich der zugehörigen Schichten angeregte Longitudinalmagnetisierung nicht vollständig aus. Dies ist jedoch mit einem weiteren Signalverlust verbunden, der das Signal-Rausch-Verhältnis noch weiter verschlechtert.

Aufgabe der vorliegenden Erfindung ist es, ein Verfahren zu schaffen, das auch dann noch einwandfrei arbeitet, wenn die untersuchten Volumenelemente klein sind im Vergleich zum Gesamtvolumen, und bei dem die zuvor in den Volumenelementen angeregte Kernmagnetisierung ohne Signalverlust ausgelesen werden kann.

Bei der Erfindung wird also durch den ersten schichtselektiven Hochfrequenzimpuls, vorzugsweise ein 90°-Hochfrequenzimpuls, die Transversalmagnetisierung in zueinander parallelen ersten Schichten angeregt. Die Transversalmagnetisierung in den verschiedenen Schichten kann dabei die gleiche oder die entgegengesetzte Phasenlage haben.

Der zweite schichtselektive Hochfrequenzimpuls, vorzugsweise ein 180°-Hochfrequenzimpuls, beeinflußt die Kernmagnetisierung in zueinander parallelen zweiten Schichten so, daß die Transversalmagnetisierung im Schnittbereich der ersten und zweiten Schichten - und nur dort - refokussiert wird. Der zweite Hochfrequenzimpuls kann so gestaltet sein, daß in einer Schicht die Phasenlage unverändert bleibt, während in einer anderen Schicht die Phasenlage demgegenüber um 180° gedreht wird. Dazu ist Voraussetzung, daß der zweite Hochfrequenzimpuls in den verschiedenen Schichten mit einer Phasenverschiebung um 90° wirksam ist. Durch das Zusammenwirken der beiden Hochfrequenzimpulse in den Schnittbereichen der ersten und zweiten Schicht, d.h. in den Volumenelementen, entstehen dort - ohne jeden Signalverlust - Spinechos mit einer entsprechenden Phasenkodierung. Die mit ihnen einhergehenden MR-Signale werden erfaßt und zur Ermittlung des MR-Spektrums in den Volumenelementen herangezogen. Da nur in den Volumenelementen Spinechos auftreten, ist die Meßgenauigkeit weitgehend unabhängig davon, wie groß der Anteil der Volumenelemente an dem den beiden Hochfrequenzimpulsen ausgesetzten Gesamtvolumen ist. Da die aus den Spinechos resultierenden MR-Signale zur Auswertung herangezogen werden, ergibt sich kein Signalverlust.

In dem Zeitintervall zwischen dem ersten Hochfrequenzimpuls und dem Auslesen des MR-Signals ist die Transversalmagnetisierung dem Einfluß des $T_2$-Zerfalls ausgesetzt. Deshalb eignet sich das erfindungsgemäße Verfahren weniger zur Erfassung von Stoffen mit geringem $T_2$ (z.B. Phosphor), während es sich für die Protonenspektroskopie sehr gut eignet.

Bei MR-Untersuchungen, die in vivo an einem Patienten durchgeführt werden, will man im allgemeinen die MR-Spektren in Volumenelementen ermitteln, die in drei Dimensionen definiert sind. Dies ist nach einer Weiterbildung der Erfindung dadurch möglich, daß vor dem ersten Hochfrequenzimpuls durch mindestens einen schichtselektiven und von einem magnetischen Gradientenfeld gefolgten Hochfrequenzimpuls die Kernmagnetisierung in den Bereiche beiderseits einer Schicht angeregt und dephasiert wird, die zu den ersten und zweiten Schichten unter einem von Null verschiedenen Winkel von vorzugsweise 90° verläuft. Danach haben der erste und der zweite Hochfrequenzimpuls nur noch Einfluß auf die Kernmagnetisierung in der erwähnten Schicht, so daß die Volumenelemente durch den Schnittbereich dieser Schicht mit den ersten und den zweiten Schichten definiert sind.

Eine bevorzugte Weiterbildung der Erfindung sieht vor, daß es innerhalb einer Repetitionszeit nacheinander auf wenigstens zwei Regionsmuster angewandt wird, wobei die Regionsmuster aus mehreren Volumenelementen bestehen, die derart angeordnet sind, daß ihre Kernmagnetisierung innerhalb einer Sequenz nur einmal angeregt und refokussiert wird. Dadurch ist es möglich, innerhalb einer Sequenz bzw. innerhalb einer Repetitionszeit mehrere Regionsmuster bzw. mehrere Gruppen von Volumenelementen zu untersuchen, und zwar ohne Signalverlust, da die Kernmagnetisierung in den Volumenelementen des jeweiligen Regionsmusters zuvor noch nicht angeregt war.

Bei der MR-Protonenspektroskopie am lebenden Patienten ist das von den an Wasser gebundenen Protonen herrührende MR-Signal um Zehnerpotenzen größer als der von den übrigen Protonen hervorgerufene Anteil. Um den Wasseranteil zu unterdrücken, ist vorgesehen, daß jede Sequenz vor dem ersten Hochfrequenzimpuls die Anregung der Kernmagnetisierung der an Wasser gebundenen Protonen durch mindestens einen frequenzselektiven Hochfrequenzimpuls und die anschließende Dephasierung dieser Kernmagnetisierung durch magnetische Gradientenfelder umfaßt.

Durch den ersten Hochfreqenzimpuls wird Transversalmagnetisierung in allen ersten Schichten angeregt. Dadurch entsteht ein FID-Signal, das sich den vom Spin-Echo abgeleiteten MR-Signal überlagert. Um das FID-Signal zu unterdrücken, ist vorgesehen, daß in jeder Sequenz im Intervall zwischen dem ersten und dem zweiten Hochfrequenzimpuls ein erstes magnetisches Gradientenfeld erzeugt wird und daß im Intervall zwischen dem zweiten Hochfrequenzimpuls und der Erfassung der MR-Signale ein zweites magnetisches Gradientenfeld erzeugt wird, dessen zeitliches Integral die gleiche Größe hat wie das erste magnetische Gradientenfeld. Infolge des refokussierend wirkenden zweiten Hochfrequenzimpulses haben die beiden magnetischen Gradientenfelder keinen Effekt auf die Transversal-Magnetisierung in Volumenelementen, während sie die Transversal-Magnetisierung in allen übrigen Teilen der ersten Schichten dephasieren, so daß diese Teile keine störenden FID-Signale mehr liefern.

Ein MR-Gerät zur Durchführung des erfindungsgemäßen Verfahrens ist versehen mit

a) einer Hochfrequenzspulenanordnung zum Erzeugen von Hochfrequenzimpulsen
b) einer Gradientenspulenanordnung zum Erzeugen zeitlich veränderlicher magnetischer Gradientenfelder
c) einer Spulenanordnung zum Empfang von MR-Signalen
d) einer Steuereinheit zum Steuern der Komponenten derart, daß folgende Schritte durchgeführt werden:

d.1) Erzeugen von Sequenzen mit

-   einem ersten schichtselektiven Hochfrequenzimpuls zur Anregung der Kernmagnetisierung in einer oder mehreren ersten Schichten, und
-   einem zweiten schichtselektiven Hochfrequenzimpuls zur Refokussierung der Kernmagnetisierung in einer oder mehreren zweiten Schichten, die die ersten Schichten unter einem von Null verschiedenen Winkel schneiden.

d.2) Variation der Phasenkodierung der Volumenelemente von Sequenz zu Sequenz,
d.3) Erfassung der bei den Sequenzen als Spin-Echo auftretenden MR-Signale,
d.4) Bildung von Linearkombinationen der MR-Signale oder daraus linear abgeleiteter MR-Daten zur Ermittlung der spektralen Kernmagnetisierungsverteilung in jeweils einem der Bereiche.

Die Erfindung wird nachstehend anhand der Zeichnungen näher erläutert. Es zeigen:

Fig. 1 ein MR-Gerät, mit dem die Erfindung ausführbar ist,

Fig. 2 den zeitlichen Verlauf verschiedener Signale bei einer Sequenz zur Ausführung der Erfindung,

Fig. 3 ein aus vier Volumenelementen zusammengesetztes Regionsmuster,

Fig. 4a bis 4d die verschiedenen Phasertkodierungen für dieses Regionsmuster,

Fig. 5a und 5b zwei Volumenelementegruppen, die in aufeinanderfolgenden Sequenzen untersucht werden können,

Fig. 6 zwei Sequenzen zur Untersuchung der in Fig. 5a und b dargestellten Gruppen,

Fig. 7a bis Fig. 7b Gruppen von Volumenelementen, mit denen in vier aufeinanderfolgenden Sequenzen ein Feld von 8 mal 8 Volumenelementen untersucht werden kann und

Fig. 8 den zeitlichen Ablauf bei diesen vier Sequenzen.

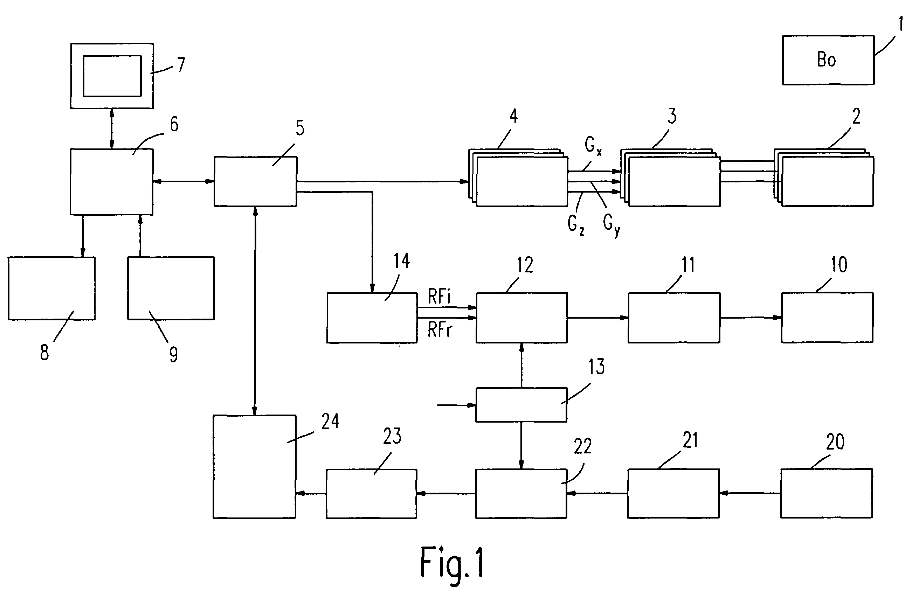

In Fig. 1 ist mit 1 ein schematisch dargestellter Hauptfeldmagnet bezeichnet, der in einem nicht näher dargestellten Untersuchungsbereich ein in z-Richtung verlaufendes stationäres und homogenes Magnetfeld mit einer Stärke von z.B. 1,5 Tesla erzeugt. Weiterhin ist eine Gradienten-Spulenanordnung 2 vorgesehen, die in dem Untersuchungsbereich in z-Richtung verlaufende magnetische Gradientenfelder mit einem Gradienten in x-, y- oder z-Richtung erzeugen kann. Die Gradientenspulenanordnung 2 wird von einer Gradientenverstärkeranordnung 3 gespeist. Der zeitliche Verlauf der magnetischen Gradientenfelder wird von einer Generatoranordnung 4 vorgegeben, die von einer Steuereinheit 5 gesteuert wird. Die Steuereinheit wirkt mit einer Workstation zusammen. Die Workstation 6 ist mit einem Monitor 7 zur Wiedergabe von MR-Bildern oder MR-Spektren versehen. Eingaben sind über eine Tastatur 8 oder eine interaktive Eingabeeinheit 9 möglich.

Die Kernmagnetisierung im Untersuchungsbereich kann durch Hochfrequenzimpulse einer Hochfrequenzspule 10 angeregt werden, die an einen Hochfrequenzverstärker 11 angeschlossen ist, der die Ausgangssignale eines Hochfrequenzsenders 12 verstärkt. Im Hochfrequerzsender werden die in einem Generator 14 gespeicherten komplexen Einhüllenden $RF_i$ und $RF_r$ für einen Hochfrequenzimpuls mit zwei um 90° gegeneinander versetzten Trägerschwingungen moduliert, die von einem Oszillator 13 geliefert werden, dessen Frequenz der Larmorfrequenz (bei einem Hauptfeld von 1,5 Tesla ca. 63 MHz) entspricht. Die für den jeweils zu erzeugenden Hochfrequenzimpuls benötigten Einhüllenden $RF_i$ und $RF_r$ werden von der Steuereinheit 5 in den Generator 14 geladen.

Die im Untersuchungsbereich erzeugten MR-Signale werden von einer Empfangsspule 20 aufgenommen und von einem Verstärker 21 verstärkt. Das verstärkte MR-Signal wird in einem Quadraturdemodulator demoduliert, so daß ein komplexes Signal entsteht, das über einen Analog-Digital-Wandler einer Recheneinheit 24 zugeführt wird, die aus den komplexen MR-Signalen durch Fouriertransformation das zugehörige Spektrum bestimmen kann und die verschiedene MR-Signale bzw. Spektren linear so miteinander kombinieren kann, daß sich das MR-Spektrum für ein einzelnes Volumenelement ergibt.

Bei der MR-Spektroskopie ist es vorteilhaft, anhand eines MR-Bildes die Bereiche festzulegen, aus denen ein MR-Spektrum ermittelt werden soll. Da die absolute Bewertung solcher Spektren oft durch die großen Unterschiede zwischen verschiedenen Patienten fragwürdig ist, ist es notwendig, Referenzwerte aus nicht pathologischen Bereichen heranzuziehen. Zu diesem Zweck können in einem auf konventionelle Weise erstellten MR-Bild, das auf dem Monitor 7 wiedergegeben wird, mittels der interaktiven Eingabeeinheit die Größe und Lage von Volumenelementen vorgegeben werden, deren MR-Spektrum ermittelt werden soll.

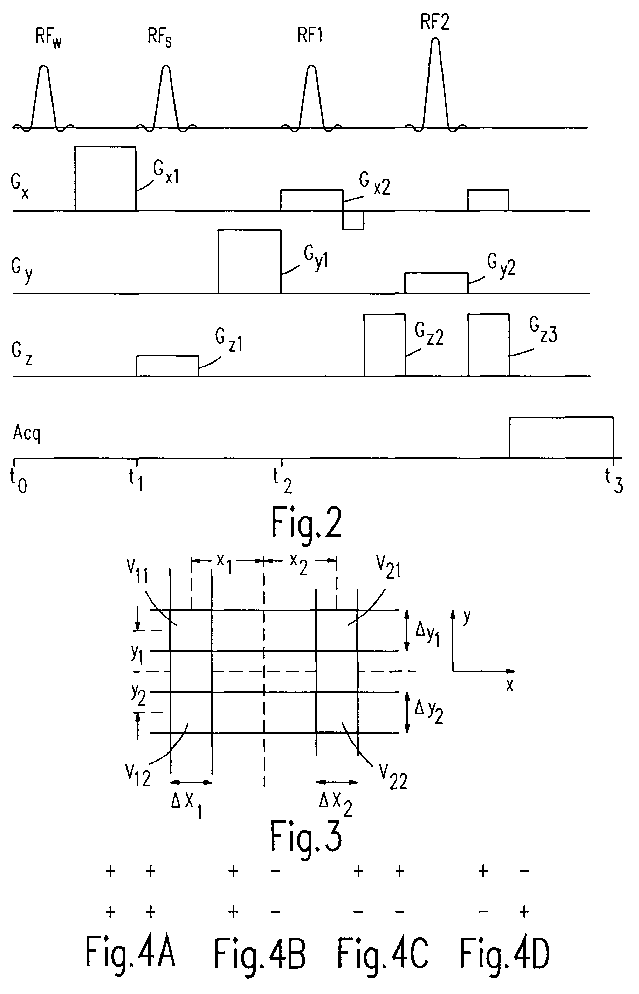

Fig. 2 zeigt die zeitliche Lage verschiedener Signale bei einer Sequenz zur Ausführung der Erfindung. Die Sequenz ist in drei Zeiträume $t_0$-$t_1$, $t_1$-$t_2$ und $t_2$-$t_3$ unterteilt. Im Zeitraum $t_0$-$t_1$ wird ein frequenzselektiver 90°-Hochfrequenzimpuls $RF_w$ (1. Zeile) erzeugt. Dieser Impuls ist auf die Larmorfrequenz von an Wasser gebundenen Protonen abgestimmt. Dadurch wird nur für diese Protonen Transversalmagnetisierung im gesamten Untersuchungsbereich erzeugt, die anschließend durch ein magnetisches Gradientenfeld $G_{x1}$ (2.Zeile) dephasiert wird. Dadurch wird erreicht, daß diese Protonen den weiteren Verlauf der Sequenz kaum noch beeinflussen.

Im Zeitraum $t_1$-$t_2$ wird ein schichtselektiver Hochfrequenzimpuls $RF_s$ erzeugt, der in Verbindung mit einem magnetischen Gradientenfeld $G_{z1}$ (4.Zeile) bewirkt, daß die Kernmagnetisierung beiderseits einer zur z-Richtung senkrechten Schicht angeregt wird. In dieser Schicht befinden sich die Volumenelemente, deren Spektrum im weiteren Verlauf zu ermitteln ist. Die beiderseits der erwähnten Schicht durch den Hochfrequenzimpuls $RF_s$ Transversalmagnetisierung wird durch ein magnetisches Gradientenfeld ($G_{y1}$, 3. Zeile) dephasiert, so daß die Bereiche außerhalb dieser zur z-Richtung senkrechten Schicht den weiteren Verlauf der MR-Untersuchung praktisch nicht mehr beeinflussen.

Im Zeitraum $t_2$-$t_3$ wird mittels zweier eindimensionaler, schichtselektiver Hochfrequenzimpulse die Phase in den Volumenelementen zweidimensional kodiert. Der erste Hochfrequenzimpuls RF1 ist ein 90°-Impuls, der in Verbindung mit einem magnetischen Gradientenfeld $G_{x2}$ in zwei zur x-Richtung senkrechten Schichten der Dicke $\Delta x_1$ und $\Delta x_2$, die sich im Abstand x1 bzw. x2 vom Koordinatenursprung befinden (vergl. Fig. 3), Transversalmagnetisierung erzeugt, d.h. die Kernmagnetisierung um 90° aus ihrer Ruhelage kippt. Dabei gibt es zwei Möglichkeiten:

a) die in den beiden Schichten erzeugte Transversalmagnetisierung hat dieselbe Phasenlage. Dies kann durch eine Hochfrequenzimpuls RF1 erreicht werden, dessen Einhüllende $RF1_{++}$ den folgenden zeitlichen Verlauf hat:

$$RF1_{++} = A\,[\mathrm{sinc}(\Delta\omega_{11}t)\,e^{-j\Delta\Omega 11t} + \mathrm{sinc}(\Delta\omega_{12}t)e^{+j\Delta\Omega 12t}] \qquad (1)$$

Dabei ist

- sinc ( ) die sogenannte Sincfunktion, d.h. sinus ( )/( ),
- $\Delta\omega_{11}$ und $\Delta\omega_{12}$ sind Frequenzen, die der Dicke der Schicht $\Delta x_1$ bzw. $\Delta x_2$ proportional sind,
- $\Delta\Omega_{11}$ und $\Delta\Omega_{12}$ sind zu den Abstände dieser Schichten vom Koordinatenursprung proportionale Frequenzen,
- A ist die Amplitude von RF1 und
- t stellt die Zeit dar.

Wenn diese Schichten gleich dick sind und ihre Abstände x1 und x2 vom Koordinatenursprung (in welchem die magnetische Feldstärke nur vom Hauptmagnetfeld, nicht aber von magnetischen Gradientenfeldern abhängt), gleich groß sind, vereinfacht sich Gleichung (1) zu

$$RF1_{++} = 2A\ \text{sinc}(\Delta\omega_1 t)\ \cos(\Delta\Omega_1 t) \tag{1'}$$

Dabei ist $\Delta\omega_1 = \Delta\omega_{11} = \Delta\omega_{12}$ und $\Delta\Omega_1 = \Delta\Omega_{11} = \Delta\Omega_{12}$.

b) die in den beiden Schichten erzeugte Transversalmagnetisierungen haben entgegengesetzte Phasenlagen. Dann gilt für den zeitlichen Verlauf der Umhüllenden $RF1_{+-}$ dieser zweiten Variante des ersten Hochfrequenzimpulses RF1 :

$$RF1_{+-} = A\ [\text{sinc}(\Delta\omega_{11} t)\ e^{-j\Delta\Omega11t} - \text{sinc}(\Delta\omega_{12} t)e^{+j\Delta\Omega12t}] \tag{2}$$

dann haben die Vektoren der Transversalmagnetisierung in den beiden Schichten eine entgegengesetzte Phasenlage. Wenn die Schichten wiederum gleich dick und gleich weit vom Koordinatenursprung entfernt sind, vereinfacht sich Gleichung (2) zu

$$RF1_{+-} = 2A\ \text{sinc}(\Delta\omega_1 t)\ \sin(\Delta\Omega_1 t) \tag{2'}$$

Nach dem ersten Hochfrequenzimpuls RF1 wird ein magnetisches Gradientenfeld $G_{z2}$ ein- und ausgeschaltet, wodurch die Transversalmagnetisierung in den beiden Schichten zunächst wieder dephasiert wird. Da danach jedoch ein 180°-Hochfrequenzimpuls RF2 erzeugt wird, der in Verbindung mit einem magnetischen Gradientenfeld $G_{y2}$ die Kernmagnetisierung in zwei zur y-Richtung senkrechten Schichten anregt, und diesem Hochfrequenzimpuls ein magnetisches Gradientenfeld $G_{z3}$ folgt, dessen zeitliches Integral genauso groß ist wie das über $G_{z2}$, hebt sich die dephasierende Wirkung von $G_{z2}$ in den Schnittbereichen der durch RF1 und RF2 angeregten Schichten auf.

Fig. 3 zeigt diese beiden Schichten der Dicke $\Delta y_1$ und $\Delta y_2$, die den Abstand y1 bzw. y2 vom Koordinatenursprung haben. Zusammen mit den beiden zur x-Achse senkrechten Schichten definieren sie in ihren Schnittbereichen vier Volumenelemente $V_{11}$, $V_{12}$, $V_{21}$ und $V_{22}$. In diesen Volumenelementen (Voxeln) wird durch die beiden Hochfrequerzimpulsen ein Spin-Echo erzeugt. Das damit einhergehende MR-Signal wird erfaßt (5. Zeile von Fig. 2), wobei der Analog-Digitalwandler 23 (Fig 1) von der Steuereinheit 5 freigegeben wird. Der zeitliche Verlauf Einfluß der Umhüllenden des zweiten Hochfrequenzimpulses RF2 hängt davon ab, wie er auf die beiden Schichten wirken soll:

a) Wenn er die Kernmagnetisierung in den beiden selektierten Schichten in gleicher Weise beeinflussen soll, dann muß die Umhüllende des zweiten Hochfrequenzimpulses der Gleichung genügen

$$RF2_{++} = B\ [\text{sinc}(\Delta\omega_{21} t)\ e^{-j\Delta\Omega21t} + \text{sinc}(\Delta\omega_{22} t)e^{+j\Delta\Omega22t}] \tag{3}$$

Dabei ist

- B ein Amplitudenfaktor, der einem Flipwinkel von 180° entspricht,
- $\Delta\omega_{21}$ und $\Delta\omega_{22}$ sind Frequenzbänder, die zu der Dicke der Schicht $\Delta_{y1}$ bzw. $\Delta_{y2}$ proportional sind und
- $\Delta\Omega_{21}$ und $\Delta\Omega_{22}$ sind Frequenzen, die den Abständen y1 und y2 der Schichten vom Koordinatenursprung proportional sind. Wenn wiederum die Schichten gleich dick und gleich weit vom Koordinatenursprung entfernt sind, vereinfacht sich Gleichung (3) zu

$$RF2_{++} = 2B\ \text{sinc}(\Delta\omega_2 t)\ \cos(\Delta\Omega_2 t) \tag{3'}$$

Dabei ist $\Delta\omega_2 = \Delta\omega_{21} = \Delta\omega_{22}$ und $\Delta\Omega_2 = \Delta\Omega_{21} = \Delta\Omega_{22}$.

b) Wenn der zweite Impuls die Transversalmagnetisierung hingegen in der zweiten Schicht in der entgegengesetzten Weise wie in der ersten Schicht beeinflussen soll, dann muß die Umhüllende des zweiten Hochfrequenzimpulses der Beziehung

$$RF2_{+-} = B\,[sinc(\Delta\omega_{21}t)\,e^{-j\Delta\Omega 21t} + j\;sinc(\Delta\omega_{22}t)e^{+j\Delta\Omega 22t}] \qquad\qquad (4)$$

genügen. Dabei wirkt er auf die zweite Schicht mit einer gegenüber der ersten Schicht um 90° versetzten Phasenlage ein. Unter den oben genannten Voraussetzungen vereinfacht sich diese Gleichung wiederum zu

$$RF2_{+-} = (1+j)\,B\,sinc(\Delta\omega_2 t)\,[cos(\Delta\Omega_2 t) - sin(\Delta\Omega_2 t)] \qquad\qquad (4')$$

Um das MR-Spektrum in den vier einzelnen Volumenelementen $V_{11}$ ... $V_{22}$ getrennt voneinander bestimmen zu können, muß die Phase in diesen vier Elementen durch die beiden Hochfrequenzimpulse vier linear voneinander unabhängige Kodierungen erfahren (d.h. keine der Kodierungen darf sich aus einer Linearkombination der anderen Kodierungen ergeben). Dies wird dann erreicht, wenn in vier verschiedenen Sequenzen die vier möglichen Kombinationen der Umhüllenden erzeugt werden. Dies wird nachfolgend in Verbindung mit Fig. 4a bis Fig. 4d erläutert:

a) Wenn die Umhüllende von RF1 der Gleichung (1) genügt und die Umhüllende von RF2 der Gleichung (3), erfahren alle vier Volumenelemente $V_{11}$... $V_{22}$ die gleiche Phasenkodierung, was in Fig. 4a mit vier Pluszeichen symbolisiert ist.

b) Wenn die Umhüllende des ersten Hochfrequenzimpulses RF1 der Gleichung (2) genügt und wenn die Umhüllende des zweiten Hochfrequenzimpulses wiederum Gleichung (3) genügt, dann erfahren die Volumenelemente $V_{11}$ und $V_{12}$ dieselbe Phasenkodierung, während die Volumenelemente $V_{21}$ und $V_{22}$ in der rechten Schicht eine dazu entgegengesetzte Phasenkodierung erhalten, was in Fig. 4b durch die beiden Minuszeichen in der rechten Spalte ausgedrückt ist.

c) Folgt einem ersten Hochfrequenzimpuls RF1 mit einer Umhüllenden gemäß Gleichung (1) ein zweiter Hochfrequenzimpuls mit einer Umhüllenden gemäß Gleichung (4), dann bleibt die Phasenkodierung der beiden oberen Volumenelemente $V_{11}$ und $V_{21}$ unverändert, während $V_{12}$ und $V_{22}$ eine dazu entgegengesetzte Phasenkodierung hat, weil der die untere Schicht beeinflussende Teil des zweiten Hochfreqenzimpulses RF2 gegenüber dem auf die obere Schicht einwirkenden Anteil eine um 90° versetzte Phasenlage hat. Es ergibt sich somit die in Fig. 4c dargestellte Konfiguration mit zwei Pluszeichen in der oberen Reihe und zwei Minuszeichen in der unteren Reihe.

d) Wirken schließlich der erste Hochfrequenzimpuls mit einer Einhüllenden gemäß Gleichung (2) und der zweite Hochfrequenzimpuls mit einer Einhüllenden gemäß Gleichung (4) zusammen, dann resultiert für das Volumenelement $V_{11}$ dieselbe Phasenkodierung (+) wie bei den Figuren 4a bis 4c. Hingegen wird die Phasenkodierung von $V_{12}$ durch RF2 invertiert und die Phasenkodierung von $V_{21}$ durch RF1. Die Phase von $V_{22}$ wird sowohl durch RF1 als auch durch RF2 invertiert, woraus sich die gleiche Phasenlage wie in $V_{11}$ ergibt. Es resultiert somit die in Fig. 4d dargestellte Kodierung.

Das in den Figuren 4a bis 4d dargestellte Kodierschema entspricht einer Vierpunkt-Hadamard-Transformation. Aus den vier MR-Signalen, die bei den in Fig. 4a bis 4d erzeugten Phasenkodierungen entstehen, läßt sich daher durch eine inverse Hadamard-Transformation das MR-Spektrum in den einzelnen Volumenelementen $V_{11}$ ... $V_{22}$ ermitteln. Bezeichnet man die bei den Phasenkodierungen gemäß Fig. 4a ... Fig. 4d akquirierten MR-Signale (5. Zeile von Fig. 2) die aus den Spin-Echos in den Volumenelementen entstehen mit Sa, Sb, Sc, Sd, dann läßt sich das MR-Spektrum für das Volumenelement $V_{11}$ aus der Summe der Signale Sa ... Sd ableiten bzw aus der Fouriertransformierten dieser Summe, während beispielsweise das MR-Signal für $V_{22}$ dadurch erhalten wird, daß die Signale Sb und Sc von der Summe der Signale Sa und Sd subtrahiert werden.

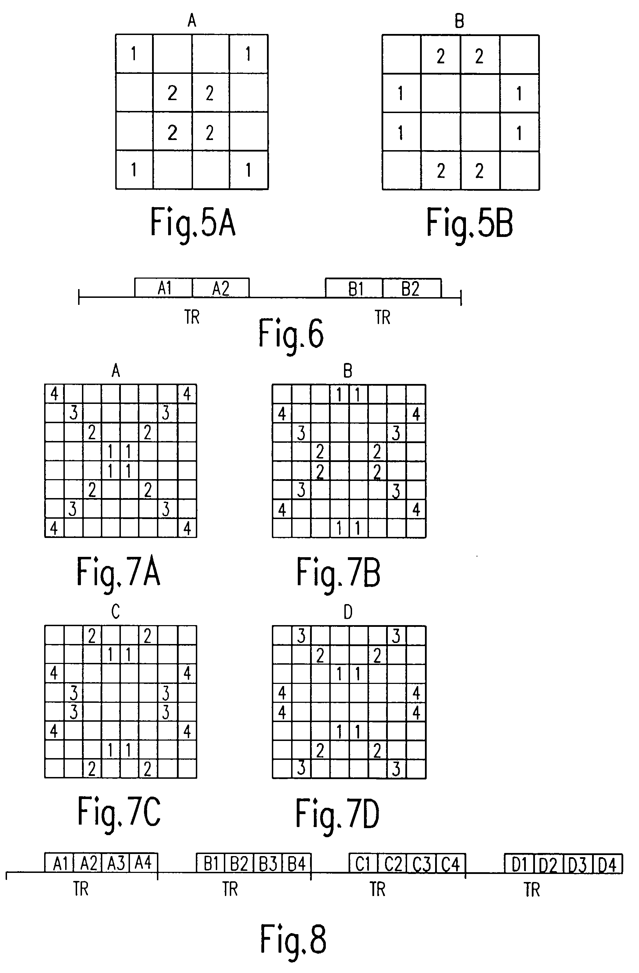

Bei spektroskopischen Untersuchungen ergeben sich relativ lange Repetitionszeiten von einigen Sekunden, damit die Transversalmagnetisierung hinreichend relaxiert ist, bevor sie erneut angeregt wird. Daraus ergeben sich relativ lange Meßzeiten für die Erfassung der benötigten MR-Signale. Man kann aber bei dem erfindungsgemäßen Verfahren innerhalb einer Repetitionszeit, d.h. bevor die Transversalmagnetisierung relaxiert ist, nacheinander verschiedene Gruppen von Volumenelementen anregen und das zugehörige MR-Signal auslesen, indem man die Signale im Zeitraum $t_0 - t_3$ (oder nur die Signale des Zeitraums im Zeitraum $t_2 - t_3$) unmittelbar anschließend wiederholt, dabei jedoch Schichten anregt, die zuvor noch nicht angeregt waren. Dadurch ist es möglich, für eine größere Anzahl von Volumenelementen ohne zusätzliche Meßzeit die Spektren zu ermitteln. Die Figuren 5a und 5b erläutern dies in Verbindung mit Fig. 6 für ein aus 4 x 4 Volumenelementen bestehendes Feld.

Gemäß Fig. 5a wird dieses Feld in zwei Regionsmuster unterteilt, wobei jedes Regionsmuster die Volumenelemente erfaßt, die gleichzeitig angeregt und refokussiert werden können, ohne sich gegenseitig zu beeinflussen. Die zu demselben Regionsmuster gehörenden Volumenelemente sind dabei jeweils mit der gleichen Ziffer (1 bzw. 2) bezeichnet. Die verbleibenden Volumenelemente lassen sich gemäß Fig. 5b wiederum mit zwei Regionsmustern besetzen, so daß es möglich ist, in einer Repetitionszeit TR nacheinander die Regionsmuster A1 und A2 aus Fig. 5a anzuregen und in der darauffolgenden Repetitionszeit die Regionsmuster B1 und B2 gemäß Fig. 5b. Die zeitliche Folge der Anregungen ergibt sich aus Fig 6. Die beiden Sequenzen müssen viermal wiederholt werden, damit sich das in Fig. 4a bis 4d dargestellte Kodierschema ergibt, so daß mit insgesamt acht Repetionszeiten das zu jedem der sechzehn Volumenelemente gehörende MR-Spektrum ermittelt werden kann.

Der Vorteil besteht darin, daß aufgrund dieser verschachtelten Anregung die Repetitionszeit TR effektiv genutzt werden kann, so daß sich die Meßzeit verkürzt, ohne daß sich daraus ein Signalverlust ergibt. Ein weiterer Vorteil ist, daß die Volumenelemente unterschiedlich groß gemacht werden können, um die Auflösung in einem pathologischen Gebiet zu vergrößern. Beispielsweise können bei dem in Fig. 5a dargestellten Muster die äußeren Schichten, zu denen die Volumenelemente A1 gehören, dicker gemacht werden als die inneren Schichten mit den Elementen A2. Weiterhin kann das beschriebene Verfahren mit herkömmlichen Verfahren kombiniert werden, z.B. um die räumliche Auflösung in jedem Volumenelement durch zusätzliche Kodiergradienten zu erhöhen.

Fig. 7a bis 7d zeigen, wie man ein Feld aus 8 x 8 Volumenelementen aufteilen kann, so daß vier verschiedene Unterteilungen A ... D entstehen, die in Fig. 7a bis Fig. 7d dargestellt sind und die jeweils vier Regionsmuster umfassen, die in einer Sequenz nacheinander angeregt und refokussiert werden können, ohne sich gegenseitig zu beeinflussen. Wie in Fig. 8 dargestellt, können daher die vier Regionsmuster, die zu einer Unterteilung gehören, nacheinander in einer Repettionszeit angeregt und refokussiert werden, so daß für die einmalige Anregung aller Volumenelemente nur vier Sequenzen nötig sind. Um alle Volumenelemente mit der erforderlichen Phasenkodierung anzuregen, müssen diese vier Sequenzen viermal wiederholt werden, so daß insgesamt 16 Sequenzen die MR-Spektren von 64 Volumenelementen ermittelt werden können.

Allgemein kann man Felder mit n mal n Volumenelementen anregen, wobei die Zahl der Anregungen davon abhängt, wieviel Volumenelemente ein Regionsmuster umfaßt. Bezeichnet man diese Zahl mit L, dann sollte L so gewählt werden, daß 2N/L ganzzahlig ist, wodurch die Zahl der Anregungen und Refokussierungen während der Dauer TR einer Sequenz vorgegeben wird.

Im vorstehenden Ausführungsbeispiel wurden durch die beiden Hochfrequenzimpulse RF1 und RF2 jeweils zwei zueinander senkrechte Schichten angeregt. Die Schichten müssen nicht notwendigerweise senkrecht zueinander verlaufen, sondern können sich auch unter einem von Null verschiedenen Winkel schneiden. Außerdem können mehr als zwei Schichten gleichzeitig angeregt werden, andererseits ist es aber auch möglich, mit einem der beiden Hochfrequenzimpulse RF1 oder RF2 nur eine Schicht anzuregen, dafür aber mit den anderen zwei Schichten oder mehr.

Anstatt eine Phasenkodierung entsprechend einer Hadamard-Transformation durchzuführen, sind auch andere Linearkombinationen der Anregung möglich, z.B. entsprechend einer Wavelet-Transformation oder einer Fouriertransformation; die Hadamard-Transformation erweist sich jedoch als besonders vorteilhaft.

Das beschriebene Verfahren kann auch mit einem Multi-Echo-Ansatz (mit weiteren refokussierenden Impulsen) kombiniert werden. Damit können die T2-Konstanten der spektralen Komponenten eines Regionsmusters bestimmt werden. Es ist aber auch möglich, mehrere Spalten (oder Zeilen) von Regionsmustern zu messen, wobei sich zwischen den Spalten (oder Zeilen) jedoch eine unterschiedliche T2-Gewichtung ergibt.

**Patentansprüche**

1. MR-Spektroskopieverfahren, bei dem durch mehrmals wiederholte Sequenzen die Kernmagnetisierung von mehreren, im Schnittbereich von je zwei Schichten befindlichen Volumenelementen ($V_{11}$ ... $V_{12}$) gleichzeitig angeregt wird, wobei die dabei erfolgende Phasenkodierung der Volumenelemente von Sequenz zu Sequenz variiert wird und wobei die spektrale Verteilung der Kernmagnetisierung in den Volumenelementen aus Linearkombinationen der in den einzelnen Sequenzen erzeugten MR-Signale abgeleitet wird,
   dadurch gekennzeichnet,
   daß in jeder Sequenz

   - ein erster schichtselektiver Hochfrequenzimpuls (RF1) erzeugt wird zur Anregung der Transversalmagnetisierung in einer oder mehreren ersten Schichten, und
   - danach ein zweiter schichtselektiver Hochfrequenzimpuls (RF2) erzeugt wird zur Refokussierung der Kernmagnetisierung in einer oder mehreren zweiten Schichten, die die ersten Schichten unter einem von Null verschiedenen Winkel schneiden,

   und daß in den verschiedendenen Sequenzen die durch die Spin-Echos in den im Schnittbereich von je einer ersten und einer zweiten Schicht befindlichen Volumenelementen hervorgerufenen MR-Signale (Sa ... Sd) erfaßt und zur Ermittlung der spektralen Verteilung der Kernmagnetisierung herangezogen werden.

2. MR-Spektroskopieverfahren nach Anspruch 1,
   dadurch gekennzeichnet, daß vor dem ersten Hochfrequenzimpuls (RF1) durch mindestens einen schichtselektiven und von einem magnetischen Gradientenfeld gefolgten Hochfrequenzimpuls (RF2) die Kernmagnetisierung in den Bereiche beiderseits einer Schicht angeregt und dephasiert wird, die zu den ersten und zweiten Schichten unter einem von Null verschiedenen Winkel von vorzugsweise 90° verläuft.

3. MR-Spektroskopieverfahren nach Anspruch 1,
dadurch gekennzeichnet, daß es innerhalb einer Repetitionszeit nacheinander auf wenigstens zwei Regionsmuster ($A_1$, $A_2$) angewandt wird, wobei die Regionsmuster ($A_1$, $A_2$) aus mehreren Volumenelementen (1,2) bestehen, die derart angeordnet sind, daß ihre Kernmagnetisierung innerhalb einer Repetitionszeit nur einmal angeregt und refokussiert wird.

4. MR-Spektroskopieverfahren nach Anspruch 1,
dadurch gekennzeichnet, jede Sequenz vor dem ersten Hochfrequenzimpuls (RF1) die Anregung der Kernmagnetisierung der an Wasser gebundenen Protonen durch mindestens einen frequenzselektiven Hochfrequenzimpuls (RF2) und die anschließende Dephasierung dieser Kernmagnetisierung durch magnetische Gradientenfelder ($G_{x1}$) umfaßt.

5. MR-Spektroskopieverfahren nach Anspruch 1,
dadurch gekennzeichnet, in jeder Sequenz im Intervall zwischen dem ersten und dem zweiten Hochfrequenzimpuls ein erstes magnetisches Gradientenfeld ($G_{z2}$) erzeugt wird und daß im Intervall zwischen dem zweiten Hochfrequenzimpuls und der Erfassung der MR-Signale ein zweites magnetisches Gradientenfeld ($G_{z2}$) erzeugt wird, dessen zeitliches Integral die gleiche Größe hat wie das erste magnetische Gradientenfeld.

6. MR-Gerät zur Durchführung des Verfahrens nach Anspruch 1 mit

    a) einer Hochfrequenzspulenanordnung (10) zum Erzeugen von Hochfrequenzimpulsen (RF)
    b) einer Gradientenspulenanordnung (2) zum Erzeugen zeitlich veränderlicher magnetischer Gradientenfelder ($G_x$, $G_y$, $G_z$)
    c) einer Spulenanordnung (20) zum Empfang von MR-Signalen
    d) einer Steuereinheit (5) zum Steuern der Komponenten derart, daß folgende Schritte durchgeführt werden:

        d.1) Erzeugen von Sequenzen mit

        -   einem ersten schichtselektiven Hochfrequenzimpuls (RF1) zur Anregung der Kernmagnetisierung in einer oder mehreren ersten Schichten, und
        -   einem zweiten schichtselektiven Hochfrequenzimpuls (RF2) zur Refokussierung der Kernmagnetisierung in einer oder mehreren zweiten Schichten, die die ersten Schichten unter einem von Null verschiedenen Winkel schneiden,

        d.2) Variation der Phasenkodierung der Volumenelemente von Sequenz zu Sequenz,
        d.3) Erfassung der bei den Sequenzen als Spin-Echo auftretenden MR-Signale,
        d.4) Bildung von Linearkombinationen der MR-Signale (Sa ... Sb) oder daraus linear abgeleiteter MR-Daten zur Ermittlung der spektralen Kernmagnetisierungsverteilung in jeweils einem der Bereiche.

Fig.1

EP 0 795 758 A1

Fig.2

Fig.3

| + | + | + | − | + | + | + | − |
|---|---|---|---|---|---|---|---|
| + | + | + | − | − | − | − | + |

Fig.4A    Fig.4B    Fig.4C    Fig.4D

A

| 1 | | | 1 |
|---|---|---|---|
| | 2 | 2 | |
| | 2 | 2 | |
| 1 | | | 1 |

**Fig.5A**

B

| | 2 | 2 | |
|---|---|---|---|
| 1 | | | 1 |
| 1 | | | 1 |
| | 2 | 2 | |

**Fig.5B**

| A1 | A2 | | B1 | B2 |
|----|----|--|----|----|
| TR | | | TR | |

**Fig.6**

A

**Fig.7A**

B

**Fig.7B**

C

**Fig.7C**

D

**Fig.7D**

| A1 | A2 | A3 | A4 | | B1 | B2 | B3 | B4 | | C1 | C2 | C3 | C4 | | D1 | D2 | D3 | D4 |
|----|----|----|----|--|----|----|----|----|--|----|----|----|----|--|----|----|----|----|
| TR | | | | | TR | | | | | TR | | | | | TR | | | |

**Fig.8**

**Europäisches Patentamt**

# EUROPÄISCHER RECHERCHENBERICHT

Nummer der Anmeldung

EP 97 20 0649

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | MAGNETIC RESONANCE IN MEDICINE, Bd. 31, 1994, Seiten 596-600, XP002029701 W.DREHER ET AL.: "Double-Echo Multislice Proton Spectroscopic Imaging Using Hadamard Slice Encoding" * see the whole document * --- | 1,3-6 | G01R33/483 |
| X,D | JOURNAL OF MAGNETIC RESONANCE, Bd. 89, Nr. 3, 1.Oktober 1990, Seiten 437-454, XP000175889 GADI GOELMAN ET AL: "TRANSVERSE HADAMARD SPECTROSCOPIC IMAGING TECHNIQUE" * Seite 438 - Seite 440 * * Seite 449 - Seite 450 * --- | 1,5,6 | |
| X | JOURNAL OF MAGNETIC RESONANCE, Bd. 41, 1980, Seiten 112-126, XP000653147 A.A.MAUDSLEY: "Multiple-Line Scanning Spin Density Imaging" * Seite 113 - Seite 119 * --- | 1,3,5,6 | |
| X | MAGNETIC RESONANCE IN MEDICINE, Bd. 24, Nr. 2, 1.April 1992, Seiten 275-287, XP000275072 WEAVER J B ET AL: "WAVELET-ENCODED MR IMAGING" * Seite 276 - Seite 279 * * Seite 286 - Seite 287 * --- | 1,6 | **RECHERCHIERTE SACHGEBIETE (Int.Cl.6)** G01R |
| A | US 4 480 228 A (BOTTOMLEY PAUL A) 30.Oktober 1984 * Spalte 4, Zeile 46 - Spalte 6, Zeile 55; Abbildung 2 * --- -/-- | 1,2,5,6 | |

Der vorliegende Recherchenbericht wurde für alle Patentansprüche erstellt

| Recherchenort | Abschlußdatum der Recherche | Prüfer |
|---|---|---|
| MÜNCHEN | 18.April 1997 | Lersch, W |

Europäisches
Patentamt

**EUROPÄISCHER RECHERCHENBERICHT**

Nummer der Anmeldung

EP 97 20 0649

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | GB 2 225 640 A (NAT RES DEV) 6.Juni 1990<br>* Seite 2, Zeile 26 - Seite 4, Zeile 10 *<br>* Seite 5, Zeile 9 - Seite 8, Zeile 15;<br>Abbildungen 1,4 *<br>----- | 1,2,5,6 | |
| | | | **RECHERCHIERTE SACHGEBIETE (Int.Cl.6)** |

Der vorliegende Recherchenbericht wurde für alle Patentansprüche erstellt

| Recherchenort | Abschlußdatum der Recherche | Prüfer |
|---|---|---|
| MÜNCHEN | 18.April 1997 | Lersch, W |

EPO FORM 1503 03.82 (P04C03)